(19) Europäisches Patentamt
European Patent Office
Office européen des brevets

(11) **EP 4 080 286 A1**

(12) **EUROPEAN PATENT APPLICATION**

(43) Date of publication:
26.10.2022 Bulletin 2022/43

(21) Application number: 21169691.9

(22) Date of filing: 21.04.2021

(51) International Patent Classification (IPC):
*G03F 7/20* (2006.01)      *G01J 1/42* (2006.01)
*G02B 5/08* (2006.01)      *H01S 3/00* (2006.01)
*H05G 2/00* (2006.01)

(52) Cooperative Patent Classification (CPC):
G03F 7/70033; G01J 1/4257; G02B 5/08;
G03F 7/70558; G03F 7/7085; H05G 2/008;
H01S 3/0014; H01S 3/2232

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventors:
• VAN DER ZANDE, Willem, Joan
5500 AH Veldhoven (NL)
• KUTLUER, Kutlu
5500 AH Veldhoven (NL)
• MATHEW, John Philip
5500 AH Veldhoven (NL)
• VAN ZWOL, Adriaan, Roelof
5500 AH Veldhoven (NL)

(74) Representative: ASML Netherlands B.V.
Corporate Intellectual Property
P.O. Box 324
5500 AH Veldhoven (NL)

(54) **MIRROR FOR PERFORMING METROLOGY IN A LASER BEAM SYSTEM, LASER BEAM SYSTEM, EUV RADIATION SOURCE AND LITHOGRAPHIC APPARATUS**

(57)    A mirror for performing metrology of a laser beam system in an EUV light source is described, the mirror comprising:
- a mirror layer having a front surface configured to receive and reflect a laser beam of the laser beam system;
- a metrology layer arranged on a back surface of the mirror layer, the metrology layer comprising a resistance grid comprising a plurality of electrically conducting segments and a plurality of electrical contacts configured to be connected to a metrology instrument.

FIG. 5a

EP 4 080 286 A1

**Description**

FIELD

The present invention relates to a mirror for performing metrology as can be used in a laser beam system for an EUV radiation source. In particular, the mirror can be applied to determine or estimate a power distribution of a laser beam received by the mirror.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In order to generate the required EUV radiation for pattering a substrate, an EUV radiation source is often applied. Such an EUV radiation source may e.g. comprise a laser beam system, e.g. a system including a $CO_2$ laser, that is arranged to deposit energy via a laser beam into a fuel, such as tin (Sn). In order to assure an effective conversion of the deposited energy to EUV radiation, accurate knowledge about the laser beam parameters, such as power, power distribution, position, may be desirable. Known solutions to determine said parameters may adversely affect the power or power distribution of the laser beam.

SUMMARY

It is an object of the present invention to provide an improved manner of determining laser beam parameters to better quantify a laser beam of a laser beam system such as a laser beam system for use in an EUV radiation source. Therefore, according to a first aspect of the present invention, there is provided a mirror for performing metrology of a laser beam system in an EUV radiation source, the mirror comprising:

    a mirror layer having a front surface configured to receive and reflect a laser beam of the laser beam system;
    a metrology layer arranged on a back surface of the mirror layer, the metrology layer comprising:

        -    a resistance grid comprising a plurality of electrically conducting segments and a plurality of electrical contacts or

        -    a resistance layer and a plurality of electrical contacts,

    whereby the plurality of electrical contacts of the resistance grid or the resistance layer are configured to be connected to a metrology instrument.

According to a second aspect of the invention, there is provided a metrology system comprising:

    -    a mirror according to the invention, and
    -    a measurement system configured to determine a resistance value of one or more electrically conductive segments of the resistance grid.

According to a third aspect of the invention, there is provide a laser beam system for an EUV radiation source, the laser beam system comprising a laser beam source and one or more metrology systems according to the present invention.
According to a fourth aspect of the invention, there is provided an EUV radiation source, the EUV radiation source comprising a laser beam system according to the present invention.
According to a fifth aspect of the invention, there is provided a lithographic system comprising an EUV radiation source according to the invention and a lithographic apparatus.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source according to the present invention;
- Figure 2 schematically depicts a cross-sectional view of a first mirror for performing metrology according to an embodiment of the present invention.
- Figure 3 schematically depicts a cross-sectional view of a second mirror for performing metrology according to an embodiment of the present invention.
- Figures 4a - 4c schematically depict plan views of portions of metrology layers as can be applied in an embodiment of the present invention.
- Figures 5a and 5b schematically depict plan views of a portion of a mirror for performing metrology according to an embodiment of the present invention.
- Figures 6a, 6b and 7 schematically depict resistance grids as can be applied in an embodiment of the present invention.
- Figure 8 schematically depicts a metrology system according to an embodiment of the present invention.
- Figure 9 schematically depicts a resistance grid as can be applied in an embodiment of the present invention.
- Figure 10 schematically depicts a laser beam system according to an embodiment of the present invention.

DETAILED DESCRIPTION

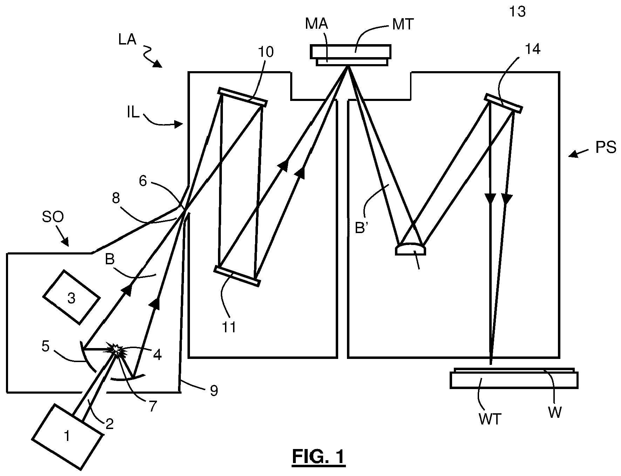

Figure 1 shows a lithographic system comprising a radiation source SO, e.g. an EUV radiation source according to the present invention, and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, e.g. a laser beam system according to the present invention, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. In an embodiment, the laser system 1 may comprise one or more mirrors for metrology according to the present invention for the purpose of determining a characteristic of the laser beam 2. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

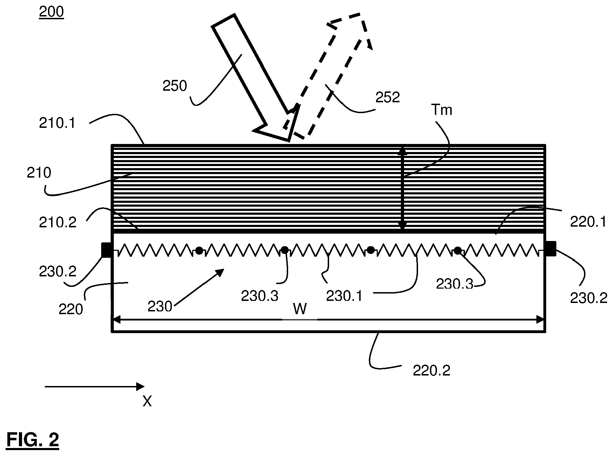

Figure 2 schematically shows a cross-sectional view of a mirror for performing metrology 200 according to an embodiment of the present invention.

The mirror 200 may e.g. be applied in a laser beam system, e.g. a laser beam system in an EUV radiation source.

In the embodiment as shown, the mirror 200 comprises a mirror layer 210 having a front surface 210.1 and a back surface 210.2. In accordance with the invention, the front surface 210.1 of the mirror layer 210 is configured to receive (arrow 250) and reflect (arrow 252) a laser beam of a laser beam system. Within the meaning of the present invention, a front surface of a mirror layer is assumed to be the surface of the mirror that faces, during use, the laser beam. Phrased differently, the front surface of the mirror layer as applied in a mirror according to the invention is deemed to be in the optical path of the laser beam, during use. In contrast, a back surface of the mirror layer of a mirror according to the invention refers to a surface that does not faces the laser beam 250. The back surface 210.2 of the mirror layer 210 may also be considered a surface opposite the front surface 210.1 of the mirror layer 210. The mirror 200 further comprises a metrology layer or metrology structure 220 that is arranged on the back surface 210.2 of the mirror layer 210. By arranging the metrology layer 220 on the back surface 210.2 of the mirror layer 210, the metrology layer 220 will not affect the reflection of the laser beam 250, 252. In particular, adverse effects such as glint or a reduced reflectivity are advantageously eliminated. In accordance with the present invention, the metrology layer 220 as applied in the mirror 200 according to the present invention comprises a resistance grid 230, the resistance grid 230 comprising a plurality of electrically conducting segments 230.1 and a plurality of electrical contacts 230.2. In accordance with the present invention, the electrical contacts 230.2 are configured to be connected to a metrology instrument or measurement system. Locations where two or more electrically conducting segments 230.1 are connected may be referred to as nodes 230.3. Note that the electrical contacts 230.2 may also be referred to as nodes of the resistance grid 230.

In an embodiment of the present invention, which will be explained in more detail below, the resistance grid 230 of the mirror 200 according to the present invention can be connected to a metrology instrument that is configured to determine, during use of the mirror 200, a resistance value of the electrically conductive segments 230.2 of the resistance grid 230 and, based on said resistance values, a temperature distribution of the resistance grid 230. Based on said temperature distribution, operational parameters of the received laser beam 250 may be derived. Such operational parameters can e.g. include a power of the received laser beam 250, a power distribution of the received laser beam 250, a position of the received laser beam 250, or a combination thereof.

Within the meaning of the present invention, layer refers to a structure or a part of a structure which is comparatively thin; i.e. a thickness of a layer, e.g. thickness Tm of the mirror layer 210 is small compared to the dimensions of the layer in a direction perpendicular to the thickness, e.g. in the indicated X-direction. Within the meaning of the present invention, a layer may also be referred to as a stratum or substrate. Further, in an embodiment, the thickness Tm may be small compared to the laser beam of the laser beam system that is measured. The thickness of a layer may e.g. be -100 μm, or a few mm. The width W of the mirror 200 may e.g. be several cm or > 10 cm or > 20 cm. The front surface 210.1 of the mirror layer 210, i.e. the surface facing, during use, the laser beam 250 may be a substantially flat surface or may be a curved surface, depending on the desired functionality of the mirror 200. The surface 210.1 may have various shapes, e.g. a rectangular shape or a circular shape.

The layers of the mirror 200, e.g. the mirror layer 210 and the metrology layer 220 may be manufactured as separate components and then assembled to realize the mirror 200. The mirror layer 210 may e.g. be a foil-like structure which is glued onto a top surface or front surface 220.1 of the metrology layer 220. Alternatively, the layers may be manufactured in sequence, e.g. starting from a base substrate, by various techniques such as etching, deposition, etc. Note that, in a similar manner as discussed above for the metrology layer 210, the front surface 220.1 of the metrology layer 220 refers to the surface of the metrology layer 220 that faces, during use, the laser beam 250. It is understood though that the laser beam 250 does not reach the metrology layer 220 but is substantially reflected by the mirror layer 210.

In the embodiment as shown, the electric contacts 230.2 are shown at a side surface of the metrology layer 220. As will be understood, the electrical contacts 230.2 may also be provided at other locations where they can be accessed, in order to them to a metrology instrument or measurement tool.

The resistance grid 230 as schematically shown in Figure 2, in particular the electrical conductive segments of the resistance grid, can be made from various materials and can be manufactured by various manufacturing techniques.

In an embodiment, the resistance grid 230 can be realized by means of printing the desired pattern onto a surface of the metrology layer. In such embodiment, an ink containing an electrically conducting material can be printed onto the surface of the metrology layer. As an example, an ink containing Ag-particles can be applied.

In an embodiment, the resistance grid can be realized by etching a desired pattern into a surface of the metrology layer, thereby generating a pattern of trenches into the surface. Said trenches may then be filled with an electrically conductive material, in order to realize the resistance grid.

Examples of electrically conductive materials that can be applied in the present invention to realize the resistance grid 230 of the metrology layer 220 of the mirror 200 according to the present invention are Ag, Au, Pt, Cu, Al, Fe, W, Ni, Mo, Sn, Zn. Other examples of materials to realize the resistance grid are semiconductor materials. In an embodiment, the resistance grid can be made from locally doped semiconductor structures. In an embodiment, the segments of the resistance grid can comprise NTC or PTC elements or materials. In a preferred embodiment, the material as applied for the manufacturing of the electrically conductive segments 230.1 of the electrical grid 230 has a high thermal coefficient of resistance $\alpha$, e.g. $\alpha > 0.0035$ per degree C. In an embodiment, the material as applied for the manufacturing of the segments 230.1 of the resistance grid have a conductivity that is at least two orders of magnitude higher than the conductivity of the material of the metrology layer 220 itself. In an embodiment, the metrology layer 220 can e.g. be made from Si or Ge.

In an embodiment, the resistance grid 230 is embedded in the metrology layer 220 of the mirror 200. In order to do so, the metrology layer 220 may comprise a cover layer, which may also be referred to as a capping layer, that is applied onto the resistance grid 230. By doing so, a contact between the resistance grid 230 and the mirror layer 210 can be avoided. In an embodiment, the cover layer or capping layer is made from the same material as the metrology layer. The cover layer may e.g. be deposited onto the grid surface using deposition techniques such as ALD, evaporation, etc. In an embodiment, SiO2 can be used as material for the cover layer. In an embodiment, the metrology layer 220 can be made from a SOI substrate wherein the oxide forms a barrier and the resistance grid is formed on the semiconductor. Alternatively, a Germanium on insulator substrate may be applied as well.

In an embodiment of the present invention, the mirror layer 210 comprises multiple layers. The mirror layer 210 may e.g. comprise a stack of layers made from different materials. As an example, the mirror layer 210 can comprise a stack of alternatingly stacked layers of a first material and layers of a second material. In an embodiment, the first material or the second material comprises Ge and/or ZeSn.

In the embodiment as shown, the resistance grid 230 is arranged near the front surface 220.1 of the metrology layer 220. Alternatively, the resistance grid 230 can also be arranged closer to the bottom surface 220.2 of the metrology layer 220.

In the embodiment as shown, the width W of the metrology layer 220 is shown to be equal to the width of the mirror layer 210. It can be pointed out that this need not be the case. The metrology layer 220 may also be wider or narrower than the mirror layer 210. The shape of the metrology layer 220, in particular the shape of the front surface 220.1 of the metrology layer 220 need not have the shape of the bottom surface of the mirror layer 210 either.

In an embodiment of the present invention, the metrology layer, e.g. metrology layer shown 220 shown in Figure 2, comprises more than one resistance grid.

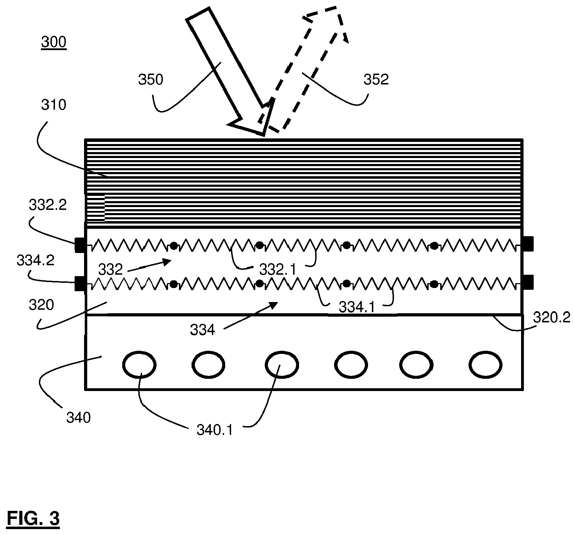

Figure 3 schematically shows such an embodiment. Figure 3 schematically shows a mirror for performing metrology 300 according to the present invention, the mirror for performing metrology 300 comprising a mirror layer 310 and a metrology layer 320, the metrology layer 320 comprising two resistance grids 332 and 334. In the embodiment as shown, both resistance grids are embedded in the metrology layer 320. The resistance grids 332 and 334 as shown can e.g. each comprise a plurality of electrically conductive segments 332.1, 334.1 and a plurality of electrical contacts 332.2, 334.2 which are configured to be connected to a metrology instrument. In an embodiment, the mirror for performing metrology according to the present invention may comprises multiple metrology layers, whereby each metrology layer comprises a resistance grid or resistance layer. In such embodiment, each resistance grid can be embedded in a different metrology layer or substrate, stratum or disk. Is such case, when one of the resistance grids would be defective, it may be replaced by replacing the metrology layer containing it.

It can be noted that the layout of the resistance grids 332 and 334 may be different. Examples of the layout of such grids are given below.

In the embodiment as shown, the mirror for performing metrology 300 further comprises a cooling layer or cooling structure 340 that is configured to cool the mirror layer 310 that receives and reflects, during use, the laser beam 350, 352. In this respect it can be noted that the mirror according to the invention, in particular the mirror layer of the mirror according to the invention, may heat up during operation. To illustrate this, one can consider the application of the mirror in a 30 kW laser system. Even if the mirror for performing metrology as applied in an optical path of the laser system would have a reflectivity of 99 %, there would still be approx. 300 W being dissipated by the mirror. Without taking suitable cooling measures, this could result in an unwanted or unacceptable heating of the mirror.

The cooling layer or cooling structure 340 as applied in an embodiment according to the present invention can e.g. be manufactured from a material having a good thermal conductivity, e.g. Cu or Al, and may comprise a plurality of cooling channels 340.1 through which a cooling fluid, e.g. water, can be made to flow. Alternatively or in addition, depending on the required cooling effort that is needed, the cooling layer may also be provided with one or more cooling fins which can then be cooled by means of a gas flow or a liquid flow. The cooling layer 340 as applied in an embodiment of the present invention can e.g. be mounted to a bottom surface 320.2 of the metrology layer 320 of the mirror for performing metrology 300. Note that the mirror for performing metrology 200 as schematically shown in Figure 2 may also be equipped with a cooling layer or cooling structure, similar to cooling layer or structure 340. In an embodiment, the metrology layer 320 may be directly deposited on cooling layer or cooling structure 340 or can be attached to it using chemicals or adhesives or by physical means such as clamping.

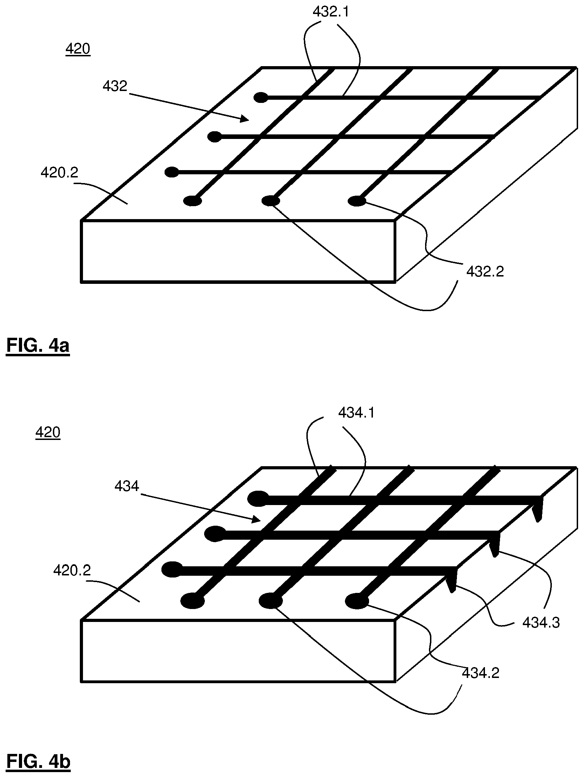

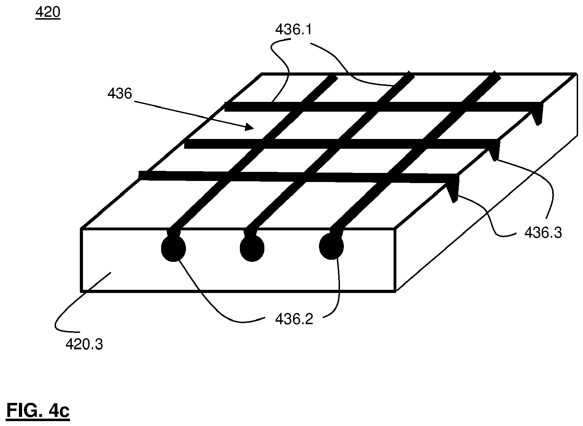

Figures 4a, 4b and 4c schematically show plan views of portions of a mirror for performing metrology according to the present invention, in particular portions of a metrology layer 420 as can be applied in a mirror for performing metrology according to the present invention. In the arrangements as shown, the metrology layer 420 as shown comprises a resistance grid 432, 434, 436, the resistance grid comprising a plurality of electrically conductive segments and a plurality of contacts. As mentioned above, various manufacturing techniques can be applied to realize the resistance grid. In Figure 4a, the resistance grid 432 can be assumed to be printed onto a surface of the metrology layer 420. The resistance grid thus forms a thin layer of electrically conductive material that is deposited, e.g. by means of printing, onto the top or front surface 420.2 of the metrology layer 420, said thin layer forming the electrically conductive segments 432.1. In a similar manner, electric contacts 432.2 can be printed onto the front surface 420.2.

In Figure 4b, the resistance grid 434 includes electrically conductive segments 434.1 that are embedded in trenches 434.3 that are etched into the front surface 420.2 of the metrology layer 420. In a similar manner, electrical contacts 434.2 can be realized by etching protrusions into the front surface and filling the protrusions with an electrically conductive material.

In Figure 4c, the trenches 436.3 used to create the electrically conductive segments 434.1 of the resistance grid 436 extend until the edge or side surface 420.3 of the metrology layer 420. Electrical contacts 436.2 may then be formed on the side surface 420.3 on the end surfaces of the material embedded in the trenches 436.3.

In an embodiment, the metrology layer can e.g. be made from a silicon substrate. Such a substrate can e.g. be 1 - 10 mm thick. Starting from such a substrate, the resistance grid as applied can be printed or etched and deposited on a top or front surface of the substrate.

When the resistance grid 430 is created, the substrate may then be covered by a cover layer or capping layer, which serves as an insulating layer, in order to electrically insulate the resistance grid. In case the resistance grid 430 is covered by an insulating layer, care should be taken that the electrical contacts remain accessible to be connected to a metrology instrument. In order to do so, the metrology layer can be provided with electrical conductors, e.g. electrically conductive wires, that are connected to the electrical contacts and are accessible for a metrology instrument. In order to make such connections, the metrology layer as applied can e.g. comprise vias for connecting the electrical wires to the electrical contacts. In an embodiment, the size of the cover layer or capping layer is smaller than the size of the metrology layer, such that the electrical contacts, which can e.g. be arranged along a contour or perimeter of the resistance grid, are easily accessible. The electrical contacts may be located between the back surface of the mirror layer and the metrology layer and/or at the same level of the capping layer or cover layer. By doing so, the resistance grid remains uncovered outside the cover layer or capping layer. The mirror layer may, in such embodiment, be arranged on the cover layer and may have the same or smaller size than the cover layer.

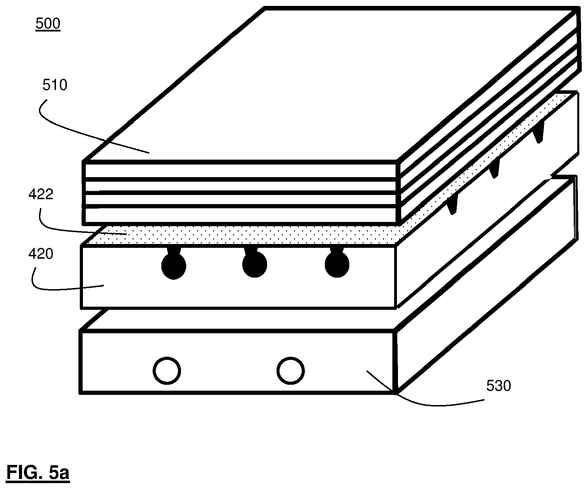

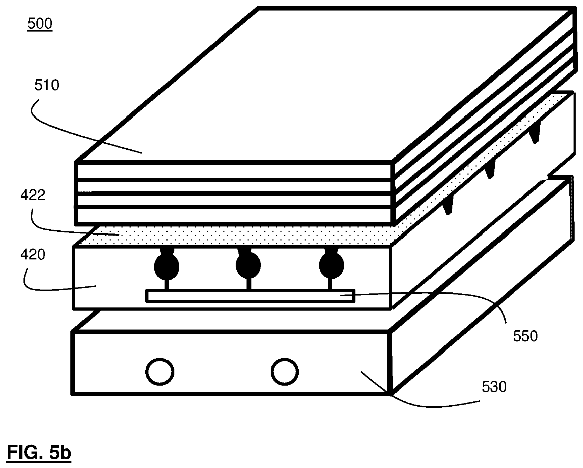

Figure 5a schematically shows a plan view of a portion of a mirror for performing metrology 500 according to the present invention including a metrology layer 420 as shown in Figure 4c, a mirror layer 510 and a cooling layer or cooling structure 530. Note that the gaps between the mirror layer 510 and the metrology layer 420 and the cooling layer 530 are merely applied for clarity purpose. It can further be pointed out that the metrology layer 420 is provided with a cover layer 422 such that the resistance grid is covered and remains insulated from the mirror layer 510 when the mirror layer 510 is mounted on the metrology layer 420. The cooling layer 530 as schematically shown comprises cooling channels 530.1 configured to receive a cooling fluid for cooling the mirror layer 510 of the mirror 500 according to the invention. In an embodiment of the present invention, schematically shown in Figure 5b, the metrology layer 420 further comprises one or more RFID tags 550, e.g. passive or active RFID tags, that are configured to emit or transmit, during use, measurement data retrieved from the electrical contacts of the resistance grid of the metrology layer 420. Such RFID tag or tags can e.g. be embedded in the metrology layer, e.g. underneath or adjacent to the resistance grid. By using such RFID tag or tags, a wiring between the electrical contacts and the metrology instrument is no longer needed.

In such embodiment, the electrical contacts of the resistance grid are thus configured to be connected to a metrology instrument in a wireless manner. Alternative means for wirelessly connecting the electrical contacts of the resistance grid to a metrology instrument can be considered as well.

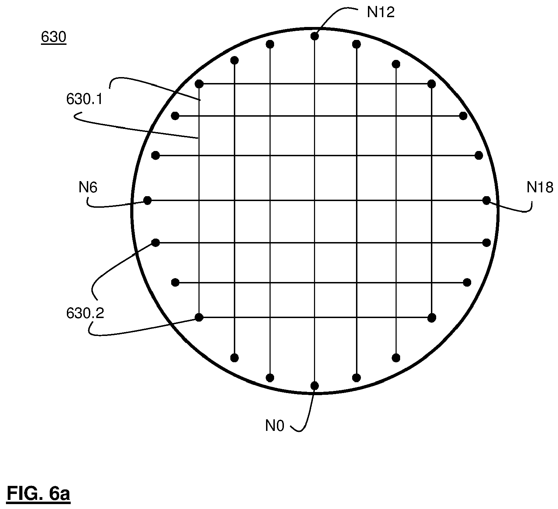

Figure 6a schematically shows a first possible layout of a resistance grid 630 as can be applied in a mirror for performing metrology according to the present invention. Figure 6a schematically a front or top view of a resistance grid 630 as can be applied in a metrology layer of a mirror for performing metrology according to the present invention. In the embodiment as shown, the resistance grid 630 comprises a plurality of electrically conductive segments 630.1 and a plurality of electrical contacts 630.2. In the embodiment as shown, the electrical contacts 630.2 are arranged along a contour or periphery of the resistance grid. In the embodiment a shown, a total of 24 electrical contacts are shown, 4 of which are identified as N0, N6, N12, N18. The electrical contacts 630.2 and the interconnections or crossings of two or more electrically conductive segments 630.1 can also be referred to as nodes of the resistance grid 630. The nodes of the resistance grid can be subdivided into a first group or subset of external or accessible nodes an a second group or subset of internal or non-accessible nodes. The electrical contacts of the resistance grid can be considered to be the first group of nodes, as they are accessible to be connected to a metrology instrument or device. In the embodiment as shown, the resistance grid is a substantially rectangular grid comprising electrically conducting segments extending along either the X-axis or the Y-axis. In an embodiment, the resistance grid is provided with 16 electrical contacts. Note that this is merely an example, the number of electrical contacts may be larger or smaller.

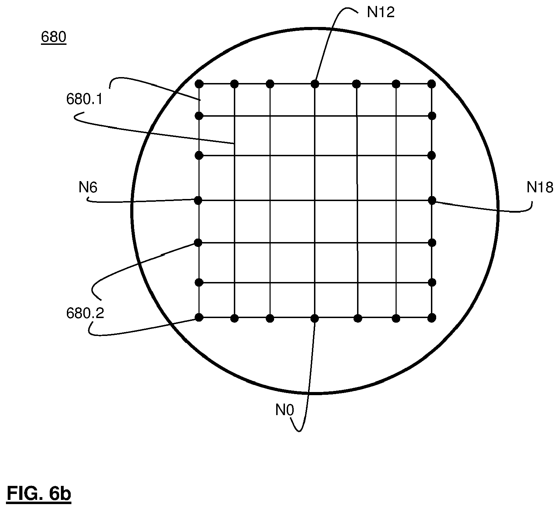

Figure 6b schematically shows an alternative substantially rectangular grid also having a total of 24 electrical contacts or nodes distributed along a contour or periphery of the resistance grid 680. In the embodiment as shown, the resistance grid 680 comprises a plurality of electrically conductive segments 680.1 and a plurality of electrical contacts 680.2.

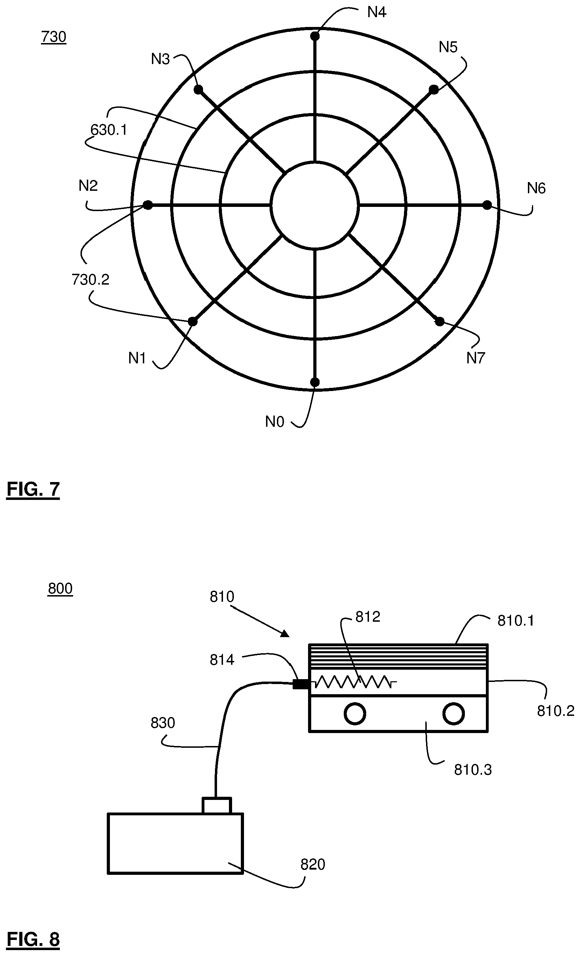

Figure 7 schematically shows an alternative layout of a resistance grid 730 as can be applied in a metrology layer of a mirror for performing metrology according to the present invention. In the embodiment as shown, the resistance grid 730 comprises a plurality of electrically conductive segments 730.1 and a plurality of electrical contacts 730.2. In the embodiment as shown, 8 electrical contacts, numbered N0 to N8, can be seen. Such a resistance grid can be referred to as a substantially radial grid having arc-shaped segments and segments that are extending radially outward.

According an aspect of the present invention, the metrology layer as applied in the mirror for performing metrology according to the present invention, can be used to determine an operating parameter or characteristic of a laser beam that is received, e.g. a power or power distribution of the laser beam as received, or a position of the laser beam as received. This aspect of the present invention can e.g. be embodied as a metrology system. In an embodiment of the present invention, a metrology system is provided, the metrology system comprising a mirror for performing metrology according to the present invention and a measurement system.

Figure 8 schematically shows such a metrology system 800 according to the invention. The metrology system 800 as shown comprises a mirror for performing metrology 810 according to the present invention and a measurement system 820. In the embodiment as shown, the mirror for performing metrology 810 comprises a mirror layer 810.1, a metrology layer 810.2 comprising a resistance grid 812 having electrical contacts 814, and a cooling structure 810.3. In accordance with the present invention, the measurement system 820 of the metrology system 800 is configured to determine, during use, a characteristic of a laser beam that is applied to the mirror for performing metrology 810. In particular, the measurement system 820 as applied can be used to determine a power of the laser beam as received by the mirror 810, or a power distribution of the laser beam as received, or a position of the laser beam as received by the mirror 810.

In order to do so, the measurement system or instrument 820 as applied in an embodiment of the present invention is configured to, during use, determine a resistance value of one or more electrically conductive segments of the resistance grid 812 applied in the metrology layer 810.2 of the mirror for performing metrology 810 of the metrology system 800. This may also be referred to as determining a resistance distribution of the resistance grid.

Based on the resistance value or values, or the resistance distribution, as determined, the measurement system 820 may then determine a corresponding temperature of the electrically conductive segments. In order to do so, use can e.g. be made from the following equation (1):

$$R_T = R_{T0} \left(1 + \alpha(T - T0)\right) \qquad (1)$$

Wherein:

$R_T$ = the resistance of the electrically conductive segment at temperature T,
$R_{T0}$ = the resistance of the electrically conductive segment at a reference temperature T0,
$\alpha$ = the thermal resistance coefficient of the electrically conductive segment.

When the temperature of one or more electrically conductive segments of the resistance grid 812 is known, this temperature or temperature distribution can be considered indicative for an operating characteristic of the laser beam that is received by the mirror 810.

In order to determine a resistance value of one or more electrically conductive segments of the applied resistance grid, the measurement system 820 of the metrology system 800 according to the present invention can be configured, in an embodiment, to apply a voltage or current to one or more of the electrical contacts of the resistance grid of the mirror for performing metrology and to measure a voltage at one or more of the remaining contacts. Such measurement can e.g. be realized using the connection 830, e.g. a multi-wire cable, arranged between the metrology layer 810.2 of the mirror 810 and the measurement system 820. In order to apply the voltage or current to the one or more electrical contacts, the measurement system 820 can e.g. comprise a power source such as a voltage source or current source.

As an example, referring to Figure 7, the measurement system or instrument 820 as applied in the metrology system according to the present invention can be configured to apply a voltage V0 to node N0, to apply a voltage of 0 volt to node N4 and to measure the voltage at one or more of the remaining contacts, e.g. at one or more of nodes N1, N2, N3, N5, N6, N7. Voltage V0 may also be referred to as the voltage difference that is applied to nodes N0 and N4.

In order to accurately determine the temperature distribution of the mirror layer of the mirror for performing metrology as applied, it would be preferred to determine the resistance value of a large portion or all of the electrically conductive segments of the resistance grid, e.g. grid 730. Considering the layout of the resistance grid as shown, the skilled person will understand that this involves determining a large number of unknowns.

In order to arrive at sufficient information to determine said large number of unknowns, the measurement system according to the present invention, may be configured to, in an embodiment, perform a plurality of measurements on the metrology layer, in particular on the resistance grid of the metrology layer.

In case the resistance grid comprises N electrical contacts, there are N contacts at which a voltage V0 can be applied. When a voltage V0 is applied at a particular node a zero voltage, or ground connection can be applied to any of the N-1 remaining contacts. As such, for a grid having N electrical contacts, there are $N*(N-1)$ manners to apply a voltage difference between two electrical contacts of the grid. Alternatively, or in addition, measurements can be performed by injecting currents in multiple, e.g. more than 2, electrical contacts and collects currents from one or more electrical contacts. As such, more than $N*(N-1)$ measurements may be available.

As such, based on the plurality of measurements as performed, a set of equations can derived, using Ohm's law and Kirchhoff's law, and solved, to arrive at a value for the resistance of the electrically conductive segments of the resistance grid. Mathematical techniques such as least square estimation and covariance matrix propagation methods may be applied as well to retrieve the unknown values for the resistance of the segments.

It can also be pointed out that the question of how to determine the resistance values of the electrically conductive segments of the resistance grid has some similarities to solving electrical impedance tomography equations. In electrical impedance tomography, an impedance distribution inside a volume is sought by applying currents at some surface electrodes and performing voltage measurements at other electrodes. Such an impedance distribution may e.g. be determined using Boundary Element Methods.

In case the resistance grid as applied in the mirror for performing metrology according to the present invention would be very dens or detailed, i.e. having a large number of comparatively small segments, similar mathematical methods may be applied to derive a resistance distribution of the resistance grid.

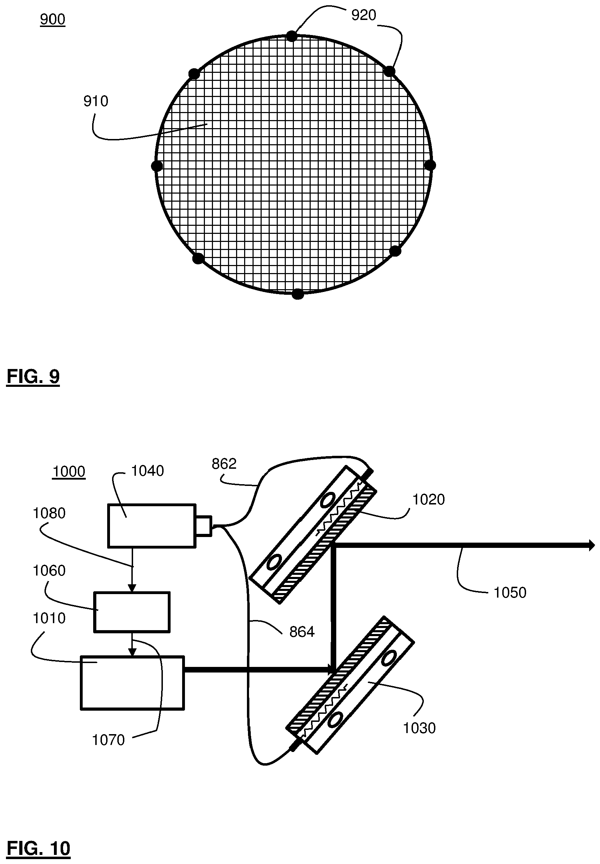

Figure 9 schematically shows such a dens resistance grid 900 having a rectangular grid of small electrically conductive segments 910 and a number of electrical contacts 920 arranged along a contour or periphery of the grid 900.

In case Boundary Element Methods or the like are applied to determine the resistance or resistance distribution of the resistance grid, the resistance grid may also be formed as a uniform electrically conductive layer or sheet, e.g. a layer or sheet made from or comprising Ag, Au, Pt, Cu, Al, Fe, W, or made from or comprising an electrically conductive ink or any other material having a sufficiently high coefficient of thermal conductivity. In such embodiment of the present invention, the resistance grid as applied in the mirror to perform metrology is thus a resistance layer. So, rather than having discrete electrically conductive segments, the metrology layer of the mirror comprises a resistance layer, e.g. an electrically conductive sheet such as a Cu- or Al-sheet, the resistance layer having a plurality of electrical contacts connected to it, e.g. along a contour or perimeter of the resistance layer. Referring to Figure 9, such embodiment may thus comprise a resistance layer, i.e. a continuous sheet or layer of electrically conductive material, instead of the dens resistance grid 900.

In an embodiment, the measurement system as applied in the metrology system according to the present invention can be configured to determine or calculate values for the resistance of the electrically conductive segments or the value for the resistance distribution, or any operating characteristic derived therefrom, at a rate of 1 Hz.

According to a further aspect of the present invention, there is provided a laser beam system for an EUV radiation source, the laser beam system comprising a laser beam source and one or more mirrors for metrology according to the invention or one or more metrology systems according to the invention.

Figure 10 schematically shows an embodiment of a laser beam system 1000 according to the present invention.

In the embodiment as shown, the laser beam system 1000 comprises a laser beam source 1010 and two mirrors for metrology 1020 and 1030 and a measurement system 1040 configured to determine, during use, a resistance value of one or more electrically conductive segments of the resistance grid applied in the metrology layer of the mirrors 1020 and 1030. The functionality of the measurement system 1040 is thus similar to the functionality of measurement system 820 shown in Figure 8. The measurement system 1040 is however configured to determine the resistance values of electrically conductive segments for two mirrors, i.e. mirrors 1020 and 130, rather than just for one. It can however be pointed out that, as an alternative, each mirror or mirrors 1020, 1030 may be equipped with its own measurement system for determining a resistance value, a resistance distribution or a temperature distribution of the resistance grid of the mirror, or an operating characteristic of the laser beam 1050 as received by the mirror. Connections 862 and 864 schematically illustrate the wiring from the measurement system 1040 to the resistance grids of the mirrors 1020, 1030 to perform the required measurements as described above. In the embodiment as shown, the mirrors 1020 and 1030 are arranged in an optical path of the laser beam 1050 and can thus be used to redirect the laser beam 1050. In the embodiment as shown, the measurement system 1040 may thus be configured to determine an operating characteristic of the laser beam 1050 received by each of the two mirrors 1020, 1030, i.e. at different locations along the optical path of the laser beam 1050.

In case the operating characteristic of the laser beam 1050 generated by the laser beam source 1010 of the laser beam system 1000 is determined at different locations along the optical path, said information may also be used to determine or assess an operating characteristic of the mirrors as applied in the laser beam system. In particular in case the measurement system 1040 is configured to perform measurements on two consecutive mirrors along the optical path, anomalies in said measurements can be used to assess the operation of the mirrors 1020, 1030. In particular, any anomaly observed between measurement data, or characteristics derived therefrom, of different mirrors, e.g. consecutive mirrors along an optical path, may be an indication of the operating state or operating condition of the mirror. As such, in an embodiment, the measurement system 1040 as applied in a laser beam system according to the present invention can be configured to determine an operating characteristic of a mirror of the laser beam system, based on a comparison of measurements on said mirrors or based on a comparison of a determined operating characteristic of the laser beam as received by each of the mirrors.

As an example, it is assumed that a defect has occurred in mirror 1020 causing a deterioration in the reflective properties of the mirror 1020. Assuming e.g. that the reflectivity of mirror 1020 has decreased from a nominal value of 99% to 98%, whereas the reflectivity of mirror 1030 remains at its nominal value, e.g. 99%.

As described above, the measurement system 1040 as applied in the present invention can be configured to determine a power or power distribution of a received laser beam, e.g. based on a determined temperature distribution of the mirror layer of the mirror, whereby said temperature distribution is derived from resistance values of the electrically conductive segments of the resistance grid of the mirror or a resistance distribution of the resistance grid. For the given example, the calculation of the power of the received laser beam will thus be based on the temperature of the mirror, which is based on the dissipation of the mirror. Since a deterioration of the reflectivity will cause an increase in the dissipation of the mirror, this deterioration will result in an erroneous calculation of the power of the received laser beam. In particular, the decreased reflectively of mirror 1020 would result in a calculated power of the laser beam as received by said mirror that is higher than the calculated power of the laser beam as received by the mirror 1030. Since mirror 1030 is upstream of the mirror 1020, these calculations cannot be right, indicating an anomaly in the operation of one of the mirrors. By comparing measurement data, or characteristics derived thereof, operating characteristics of the applied mirrors such as a likelihood of a defect, a deterioration state or a reflectivity can be determined or estimated.

Such information may e.g. be useful to determine whether or not a preventive maintenance or repair of a component of the laser beam system 1000.

In the embodiment as shown in Figure 10, the laser beam system 1000 further comprises a control system 1060 that is configured to control an operation of the laser beam source 1010, in particular to control the generation of the laser beam 1050. The control system 1060 may in this respect be configured to determine control signals 1070 for controlling the laser beam source 1010. In an embodiment of the present invention, the measurement data obtained by the measurement system 1040, or any operating characteristic derived therefrom, can be provided, as feedback, to the control system 1070 of the laser beam system, as indicted by data signal 1080. Based on said data, the control system 1060 of the laser beam system can adjust an operation of the laser beam system, in particular an operating characteristic of the laser beam 1050 as generated by the laser beam source 1010. As an example, based on the measurement data obtained by the measurement system 1040, a drift or displacement of the laser beam 1050 may be detected, whereupon a mirror steering system of the laser beam system 1000 can be configured to steer one or more mirrors of the laser beam system, in order to realign the laser beam. It can be noted that the one or more mirrors that can be steered by such a mirror steering system may include one or more of the mirrors 1020, 1030 and/or may include additional mirrors of the laser beam system as applied.

According to a further aspect of the present invention, there is provided an EUV radiation source, the EUV radiation source comprising a laser beam system according to the present invention. Such an EUV radiation source may advantageously be applied in a lithographic system according to the present invention, such system comprising an EUV radiation source according to the present invention and a lithographic apparatus. Such an EUV radiation source and lithographic apparatus are schematically described with reference to Figure 1.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the clauses set out below.

Clause a mirror for performing metrology of a laser beam system in an EUV light source, the mirror comprising:

a mirror layer having a front surface configured to receive and reflect a laser beam of the laser beam system; a metrology layer arranged on a back surface of the mirror layer, the metrology layer comprising: a resistance grid comprising a plurality of electrically conducting segments and a plurality of electrical contacts, or a resistance layer comprising a plurality of electrical contacts, whereby the plurality of electrical contacts of the resistance grid or the resistance layer are configured to be connected to a metrology instrument.

Clause 2: The mirror according to clause 1, wherein the resistance grid comprises a plurality of nodes, each electrically conducting segment forming a connection between a pair of nodes of the plurality of nodes.

Clause 3: The mirror according to clause 2, wherein the plurality of electrical contacts is provided by a subset of the plurality of nodes.

Clause 4: The mirror according to any of the preceding clauses, wherein the metrology layer comprises a substrate layer.

Clause 5: The mirror according to clause 4, wherein the substrate layer comprises silicon.

Clause 6: The mirror according to clause 4 or 5, wherein the resistance grid is formed by means of printing a corresponding pattern onto a surface of the substrate layer using an electrically conducting ink.

Clause 7: The mirror according to clause 4 or 5, whereby the resistance grid is formed by etching trenches in a surface of the substrate layer and providing an electrical conductor in the trenches, so as to form the plurality of electrically conducting segments and the plurality of electrical contacts.

Clause 8: The mirror according to any of the preceding clauses, wherein the surface of the metrology layer is covered by a protective layer.

Clause 9: The mirror according to any of the clauses 4 to 8, wherein the surface of the substrate layer that is provided with the resistance grid faces the back surface of the mirror layer.

Clause 10: The mirror according to any of the preceding clauses, wherein the electrical contacts are arranged along a contour or periphery of the resistance grid.

Clause 11: The mirror according to any of the preceding clauses, wherein the mirror comprises a stack of metrology layers arranged on the back surface of the mirror layer.

Clause 12: The mirror according to any of the preceding clauses, further comprising a cooling layer configured to cool the mirror layer.

Clause 13: The mirror according to clause 12, wherein the cooling layer comprises one or more cooling channels configured to receive a cooling fluid.

Clause 14: The mirror according to clause 12 or 13, wherein the cooling layer is arranged on a back surface of the metrology layer.

Clause 15: The mirror according to any preceding clause, wherein the resistance grid is a substantially rectangular grid or a substantially radial grid.

Clause 16: Metrology system comprising:

a mirror according to any of the preceding clauses, and

a measurement system configured to determine a resistance value of one or more electrically conductive segments of the resistance grid.

Clause 17: The metrology system according to clause 16, wherein the measurement system is configured to:

connect one or more of the electrical contacts to a power source;

measure a voltage or current at one or more of the electrical contacts that are not connected to the power source;

determine, based on the measured voltage or current, the resistance value of the one or more conductive segments of the plurality of conductive segments.

Clause 18: The metrology system according to clause 16 or 17, wherein the measurement system is further configured to estimate a temperature distribution of the mirror layer, based on the determined resistance value.

Clause 19: The metrology system according to clause 18, wherein the measurement system is further configured to determine, during use, an operating characteristic of a laser beam received by the mirror.

Clause 20: The metrology system according to clause 19, wherein the operating characteristic comprises a power of the laser beam, a power distribution of the laser beam or a position of the laser beam.

Clause 21: Laser beam system for an EUV radiation source, the laser beam system comprising:

a laser beam source, and

one or more mirrors for metrology according to any of the clauses 1 to 15 or one or more metrology systems according to any of the clauses 16 to20.

Clause 22: The laser beam system according to clause 21, wherein the one or more mirrors or the one or more metrology systems are arranged in an optical path of a laser beam of the laser beam system.

Clause 23: The laser beam system according to clause 22, comprising two or more metrology systems and wherein the two or more metrology systems are configured to determine an operating characteristic of the laser beam received by each of the two or more mirrors of the two or more metrology systems.

Clause 24: The laser beam system according to clause 23, wherein a measurement system of the two or more metrology systems is configured to determine an operating characteristic of a mirror of the two or more metrology systems, based on a comparison of the determined operating characteristic of the laser beam as received by each of the two or more mirrors of the two or more metrology systems.

Clause 25: The laser beam system according to clause 24, wherein the operating characteristic of the mirror comprises a likelihood of a defect, a deterioration state or a reflectivity.

Clause 26: An EUV radiation source comprising a laser beam system according to any of the clauses 21 to 25.

Clause 27: A lithographic system comprising an EUV radiation source according to clause 26 and a lithographic apparatus.

**Claims**

1. A mirror for performing metrology of a laser beam system in an EUV light source, the mirror comprising:

    - a mirror layer having a front surface configured to receive and reflect a laser beam of the laser beam system;
    - a metrology layer arranged on a back surface of the mirror layer, the metrology layer comprising:

        ◦ a resistance grid comprising a plurality of electrically conducting segments and a plurality of electrical contacts, or
        ◦ a resistance layer comprising a plurality of electrical contacts,

    whereby the plurality of electrical contacts of the resistance grid or the resistance layer are configured to be connected to a metrology instrument.

2. The mirror according to claim 1, wherein the resistance grid comprises a plurality of nodes, each electrically conducting segment forming a connection between a pair of nodes of the plurality of nodes, and
   wherein the plurality of electrical contacts is provided by a subset of the plurality of nodes.

3. The mirror according to claim 2, wherein the metrology layer comprises a substrate layer and the resistance grid is formed by means of printing a corresponding pattern onto a surface of the substrate layer using an electrically conducting ink.

4. The mirror according to claim 2, the metrology layer comprises a substrate layer and whereby the resistance grid is formed by etching trenches in a surface of the substrate layer and providing an electrical conductor in the trenches, so as to form the plurality of electrically conducting segments and the plurality of electrical contacts.

5. The mirror according to any of the preceding claims, wherein the surface of the metrology layer is covered by a protective layer.

6. The mirror according to any of the preceding claims, wherein the metrology layer comprises a substrate layer and the surface of the substrate layer that is provided with the resistance grid faces the back surface of the mirror layer.

7. The mirror according to any of the preceding claims, wherein the mirror comprises a stack of metrology layers arranged on the back surface of the mirror layer.

8. The mirror according to any of the preceding claims, further comprising a cooling layer configured to cool the mirror layer, and wherein the cooling layer is arranged on a back surface of the metrology layer.

9. Metrology system comprising:

    - a mirror according to any of the preceding claims, and
    - a measurement system configured to determine a resistance value of one or more electrically conductive segments of the resistance grid.

10. The metrology system according to claim 9, wherein the measurement system is configured to:

   a. connect one or more of the electrical contacts to a power source;
   b. measure a voltage or current at one or more of the electrical contacts that are not connected to the power source;
   c. determine, based on the measured voltage or current, the resistance value of the one or more conductive segments of the plurality of conductive segments.

11. The metrology system according to claim 9 or 10, wherein the measurement system is further configured to estimate a temperature distribution of the mirror layer, based on the determined resistance value, and
   wherein the measurement system is further configured to determine, during use, an operating characteristic of a laser beam received by the mirror, and
   wherein the operating characteristic comprises a power of the laser beam, a power distribution of the laser beam or a position of the laser beam.

12. Laser beam system for an EUV radiation source, the laser beam system comprising:

   - a laser beam source, and
   - one or more mirrors for metrology according to any of the claims 1 to 8 or one or more metrology systems according to any of the claims 9 to 11.

13. The laser beam system according to claim 12, comprising two or more metrology systems and two or more mirrors, and wherein the two or more metrology systems are configured to determine an operating characteristic of the laser beam received by each of the two or more mirrors of the two or more metrology systems.

14. The laser beam system according to claim 13, wherein a measurement system of the two or more metrology systems is configured to determine an operating characteristic of a mirror of the two or more metrology systems, based on a comparison of the determined operating characteristic of the laser beam as received by each of the two or more mirrors of the two or more metrology systems,
   wherein the operating characteristic of the mirror comprises a likelihood of a defect, a deterioration state or a reflectivity.

15. An EUV radiation source comprising a laser beam system according to any of the claims 12 to 14.

**FIG. 1**

200

250

252

Tm

210.1

210

210.2

220.1

230.2

230.3

230.1

230.3

230.2

220

230

W

220.2

X

**FIG. 2**

300

350                                                    352

310

332.2

334.2

332          332.1

320                    334.1

334                                    320.2

340

340.1

**FIG. 3**

420

432.1

432

420.2

432.2

**FIG. 4a**

420

434.1

434

420.2

434.3

434.2

**FIG. 4b**

420

436.1

436

436.3

436.2

420.3

**FIG. 4c**

500

510

422

420

530

**FIG. 5a**

500

510

422

420

550

530

**FIG. 5b**

**FIG. 6a**

**FIG. 6b**

730

N4

N3

N5

630.1

N2

730.2

N1

N6

N7

N0

**FIG. 7**

800

810

812

810.1

814

810.2

830

810.3

820

**FIG. 8**

900

920

910

**FIG. 9**

1000    1040    862    1020

1080

1060

1010

1070    864    1030

1050

**FIG. 10**

Europäisches
Patentamt

European
Patent Office

Office européen
des brevets

## EUROPEAN SEARCH REPORT

Application Number

EP 21 16 9691

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 3 939 706 A (PINSON GEORGE T)<br>24 February 1976 (1976-02-24)<br>* abstract *<br>* figures 1,2,4,5 *<br>* column 1, lines 12-16 *<br>* column 2, line 32 - column 3, line 58 *<br>* column 4, line 20 - column 5, line 61 *<br>----- | 1,5-12<br><br>2-4,<br>13-15 | INV.<br>G03F7/20<br>G01J1/42<br>G02B5/08<br>H01S3/00<br>H05G2/00 |
| A | US 2021/066877 A1 (SMOLAREK SZYMON DOMINIK [NL]) 4 March 2021 (2021-03-04)<br>* abstract *<br>* figures 1,2 *<br>* paragraphs [0002], [0042], [0056], [0057], [0074] - [0078] *<br>----- | 1-15 | |
| A | US 5 172 392 A (BOISSELIER DIDIER [FR])<br>15 December 1992 (1992-12-15)<br>* abstract *<br>* figures 1-3 *<br>* column 1, lines 9-15 *<br>* column 4, line 7 - column 5, line 16 *<br>----- | 1-15 | |
| A | US 4 692 623 A (ROBERTS THOMAS G [US] ET AL) 8 September 1987 (1987-09-08)<br>* abstract *<br>* figures 1,2 *<br>* column 1, lines 52-57 *<br>* column 2, line 35 - column 3, line 54 *<br>----- | 1-15 | TECHNICAL FIELDS SEARCHED (IPC)<br><br>G03F<br>H05G<br>G01J<br>H01S<br>G02B |

The present search report has been drawn up for all claims

| Place of search | Date of completion of the search | Examiner |
|---|---|---|
| Munich | 21 October 2021 | Andersen, Ole |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 21 16 9691

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2021

| Patent document cited in search report | | Publication date | Patent family member(s) | | Publication date |
|---|---|---|---|---|---|
| US 3939706 | A | 24-02-1976 | NONE | | |
| US 2021066877 | A1 | 04-03-2021 | CN | 111742454 A | 02-10-2020 |
| | | | JP | 2021515261 A | 17-06-2021 |
| | | | KR | 20200120923 A | 22-10-2020 |
| | | | NL | 2022443 A | 27-08-2019 |
| | | | TW | 201942681 A | 01-11-2019 |
| | | | US | 2021066877 A1 | 04-03-2021 |
| | | | WO | 2019162038 A1 | 29-08-2019 |
| US 5172392 | A | 15-12-1992 | AT | 121538 T | 15-05-1995 |
| | | | CA | 2045350 A1 | 27-12-1991 |
| | | | DE | 69108993 T2 | 23-11-1995 |
| | | | EP | 0463982 A1 | 02-01-1992 |
| | | | ES | 2074248 T3 | 01-09-1995 |
| | | | JP | 2614374 B2 | 28-05-1997 |
| | | | JP | H06310777 A | 04-11-1994 |
| | | | US | 5172392 A | 15-12-1992 |
| US 4692623 | A | 08-09-1987 | NONE | | |

EPO FORM P0459

For more details about this annex : see Official Journal of the European Patent Office, No. 12/82